# DEMANDE DE BREVET EUROPEEN

(11) **EP 2 648 313 A2**
(43) Date de publication de la demande: **09.10.2013**
(21) Numéro de dépôt: 13162404.1
(22) Date de dépôt: 04.04.2013
(51) Int. Cl.: H02J 13/00, H02B 1/015

(54) **Tableau électrique et procédé de contrôle d'une installation électrique comprenant un tel tableau électrique**

(30) Priorité: 06.04.2012 FR 1253219
(71) Demandeur: Electricité de France, 75008 Paris (FR)
(72) Inventeur: Pignier, Daniel, 92340 Bourg la Reine (FR); Menga, David, 91370 Verrieres le Buisson (FR)
(74) Mandataire: Cabinet Plasseraud

(57) **Abrégé**

L'invention concerne un tableau électrique (100), comprenant :
- au moins une rangée de disjoncteurs (101, 101') ;
- au moins un capteur de courant (105, 105') par disjoncteur, adapté à mesurer un départ de courant et une différence de potentiel ;
- au moins une unité de traitement électronique (110, 110') collectant des données de chaque capteur de courant ;
- une mémoire archivant les données collectées de chaque capteur de courant;
- au moins une interface de communication (115).

Le tableau électrique selon l"invention permet une mesure détaillée de la consommation électrique dans le logement et de conserver localement les données mesurées pour une utilisation à la discrétion du consommateur.

## Description

L'invention concerne le domaine des installations électriques, et plus spécifiquement un tableau électrique permettant à un consommateur d'énergie électrique de gérer les installations de son logement.

Les fournisseurs d'énergie électrique proposent à des abonnés - consommateurs d'électricité - des compteurs électriques qui peuvent être munis d'une électronique de gestion.

Par ailleurs, l'installation électrique du consommateur est généralement dotée d'un tableau électrique qui regroupe les commandes de coupure des circuits électriques du logement, les systèmes de protection des circuits ainsi que les protections spécifiques aux personnes. Le tableau électrique peut également intégrer un système de gestion locale de l'énergie consommée, i.e. permettant une programmation des usages des appareils de l'installation selon un paramétrage du consommateur ou selon des consignes de téléinformation délivrées par le compteur électrique en fonction de l'abonnement souscrit.

Les fournisseurs d'énergie électrique cherchent à réguler et à anticiper la consommation électrique chez les abonnés. En effet, les moyens actuels de production d'électricité réagissent difficilement aux fortes variations de la demande en énergie. Les fournisseurs d'énergie électrique cherchent donc à recueillir des informations sur la consommation chez un abonné pour réguler sa consommation par des commandes de téléinformation provenant du compteur. Il existe ainsi des « box opérateurs » comprenant des modules de prises d'information installés chez un abonné et communiquant des informations au fournisseur.

Le document EP-A-2 047 577 décrit un procédé et système de gestion de consommation électrique dans lequel des données recueillies par le tableau électrique sont transférées à un serveur qui les lit, les interprète et envoie une commande de coupure de l'alimentation de certains équipements du logement.

Ces systèmes existants ne sont pas contrôlés par l'abonné mais par le fournisseur d'énergie, et ne permettent qu'une collecte partielle d'informations.

Il existe par ailleurs des tableaux électriques permettant le contrôle de la charge ou la détection de défauts électriques (US-A-6 246 566, US-A-6 865 073 ou US-A-7 907 388), mais ces tableaux ne permettent qu'une collecte partielle d'informations et ne propose par d'archivage local des données collectées.

Il existe donc un besoin pour un système installé chez un consommateur et contrôlé par ce dernier, qui permette de collecter un ensemble d'informations relatives aux usages chez ce consommateur et de conserver ces informations à la disposition du consommateur.

A cet effet, l'invention propose un tableau électrique permettant une mesure détaillée de la consommation électrique dans le logement et de conserver localement les données mesurées pour une utilisation à la discrétion du consommateur.

Le tableau électrique peut ainsi devenir le coeur d'une plateforme de service du logement, en lieu et place ou en complément du compteur contrôlé par le fournisseur d'énergie électrique.

Plus particulièrement, l'invention concerne un tableau électrique comprenant :
- au moins une rangée de disjoncteurs ;
- au moins un capteur de courant par disjoncteur, adapté à mesurer un départ de courant et une différence de potentiel ;
- au moins une unité de traitement électronique adaptée à collecter des données de chaque capteur de courant ;
- une mémoire adaptée à archiver les données collectées de chaque capteur de courant ;
- au moins une interface de communication.

Selon les modes de réalisation, le tableau électrique selon l'invention peut comprendre en outre une ou plusieurs des caractéristiques suivantes :
- l'unité de traitement électronique est adaptée à collecter et archiver en outre des données d'un moins un capteur domestique ;
- l'unité de traitement électronique est adaptée à transmettre, sur requête, des données collectées et archivées ;
- l'unité de traitement électronique est paramétrée pour détecter des anomalies de fonctionnement à partir des données collectées et adaptée à émettre une alerte ;
- l'interface de communication permet une consultation de l'ensemble des données collectées et archivées ;
- une pluralité d'unités de traitement électroniques, une des unités étant choisie comme unité maitre ;
- l'interface de communication est au moins une parmi une connexion Ethernet, une connexion radio, une connexion WiFi, une connexion courant porteur de ligne (CPL) ;
- une source de puissance autonome ;

L'invention concerne aussi une installation électrique comprenant au moins un tableau électrique selon l'invention. Une telle installation peut comprendre en outre au moins un capteur domestique et/ou au moins un dispositif comprenant une application logicielle permettant de consulter l'ensemble des données collectées et archivées.

L'installation électrique selon l'invention peut comprendre en outre au moins une multiprise comprenant :
- au moins un capteur de courant par prise, adapté à mesurer un départ de courant et une différence de potentiel ;
- une unité de traitement électronique adaptée à collecter des données de chaque capteur de courant ;
- une mémoire adaptée à archiver les données collectées de chaque capteur de courant ;
- au moins une interface de communication.

Selon les modes de réalisation, l'unité de traitement électronique de la multiprise est adaptée à collecter et archiver en outre des données d'au moins un capteur domestique et/ou est adaptée à transmettre à l'unité de traitement électronique du tableau l'ensemble de ses données collectées et archivées.

L'installation électrique selon l'invention peut comprendre en outre au moins une prise comprenant :
- au moins un capteur de courant adapté à mesurer un départ de courant et une différence de potentiel ;
- une unité de traitement électronique adaptée à collecter des données du capteur de courant ;
- une mémoire adaptée à archiver les données collectées du capteur de courant ;
- au moins une interface de communication.

Selon les modes de réalisation, l'unité de traitement électronique de la prise est adaptée à collecter et archiver en outre des données d'au moins un capteur domestique et/ou est adaptée à transmettre à l'unité de traitement électronique du tableau l'ensemble de ses données collectées et archivées.

L'invention concerne en également un procédé de contrôle d'une installation électrique domestique selon l'invention, le procédé comprenant les étapes de :
- collecte et archivage des données des capteurs ;
- transmission, sur requête, des données collectées et archivées ;
- consultation, sur requête, des données collectées et archivées.

Selon un mode de réalisation, le procédé selon l'invention peut comprendre en outre les étapes de :
- surveillance des données collectées pour détecter des anomalies de fonctionnement ;
- émission d'une alerte en cas d'anomalie détectée.

Selon un mode de réalisation, l'installation peut comprendre une pluralité d'unités de traitement électroniques, le procédé comprenant alors en outre l'étape de choix d'une des unités comme unité maitre. L'unité maitre peut assurer la transmission et la consultation, sur requête, de l'ensemble des données collectées et archivées

D'autres caractéristiques et avantages de l'invention apparaîtront à la lecture de la description détaillée ci-après, et des figures annexées qui représentent :
- figure 1, un tableau électrique selon l'invention ;
- figure 2, un exemple d'installation comprenant un tableau selon l'invention.

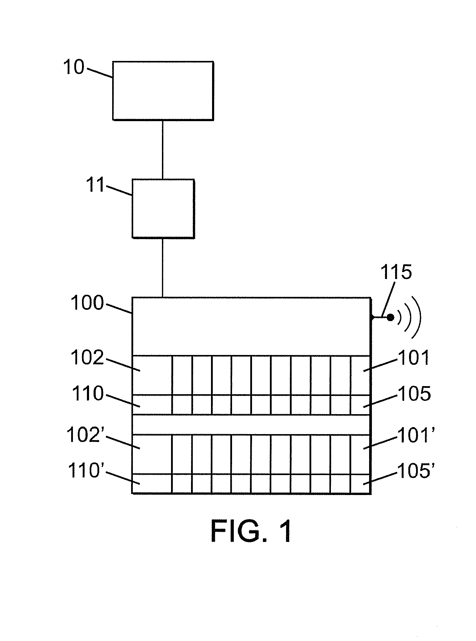

La figure 1 montre un tableau électrique 100 installé chez un abonné en aval d'un compteur électrique 10 mis à disposition par un fournisseur d'énergie électrique. Un disjoncteur principal 11 est généralement inséré entre le compteur 10 et le tableau 100.

Le tableau électrique 100 comprend au moins une rangée de disjoncteurs 101, 101'. De manière connue en soi, chaque disjoncteur est adapté à interrompre le courant électrique délivré à une partie de l'installation électrique du logement de l'abonné en cas de courant de surcharge ou en cas de court-circuit sur la partie de l'installation. Chaque rangée de disjoncteurs 101, 101' est associée à un disjoncteur différentiel 102, 102', par exemple à 30 mA, assurant une protection des personnes en détectant les fuites de courant à la terre dans l'installation électrique.

Le tableau électrique 100 selon l'invention comprend aussi au moins un capteur de courant 105, 105' par disjoncteur 101, 101'. On peut prévoir de placer deux capteurs de courant pour mesurer d'une part un départ et d'autre part un retour de courant. Les capteurs de courant 105, 105' sont ainsi adaptés à mesurer un départ de courant et une différence de potentiel au niveau de chaque disjoncteur 101, 101'. Tout défaut électrique intervenant dans une partie de l'installation peut ainsi être détecté au moyen de ces capteurs 105, 105' et le défaut peut être localisé dans l'installation en fonction du disjoncteur 101, 101' associé.

Le tableau électrique 100 selon l'invention comprend en outre au moins une unité de traitement électronique 110, 110' collectant des données de chaque capteur de courant 105, 105'. Ces données sont collectées puis archivées dans une mémoire dans le tableau. Une telle mémoire peut être une carte « microSD » (microcarte Digitale Sécurisée) insérée dans le tableau électrique. Le tableau électrique 100 constitue ainsi une « boîte noire » des usages électriques du logement. Les capteurs de courant 105, 105' recueillent des informations relatives à la consommation de chaque appareil ou groupe d'appareils reliés à un disjoncteur donné et l'unité de traitement électronique 110, 110' collecte et archive ces données. Le consommateur peut alors choisir de la manière dont il dispose de ces informations collectées et archivées.

Notamment, le tableau 100 comprend au moins une interface de communication 115. Une telle interface de communication 115 peut être une connexion Ethernet, une connexion radio, une connexion WiFi, une connexion CPL (Courant Porteur de Ligne) ou toute autre interface permettant au consommateur de consulter les informations collectées et archivées et/ou permettant un transfert de ces informations vers une unité extérieure, par exemple un ordinateur ou un coffre fort électronique ou autre. Par exemple, les données collectées et archivées dans la mémoire du tableau 100 peuvent être dupliquées automatiquement dans un coffre fort électronique sécurisé avec une fréquence déterminée selon un paramétrage du consommateur.

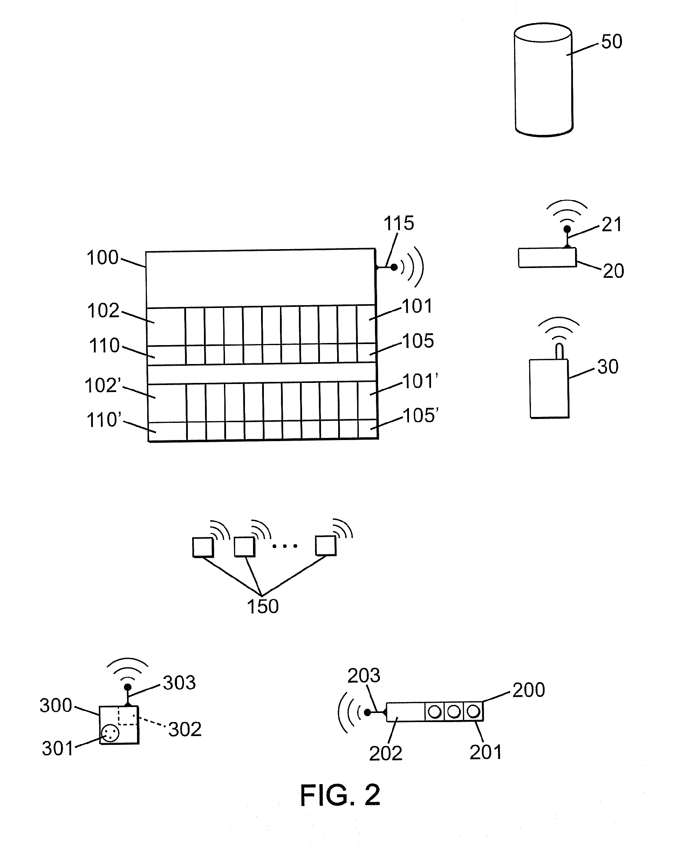

L'interface de communication 115 peut aussi permettre de recueillir des informations complémentaires dans l'installation, comme cela sera décrit en référence à la figure 2. Par exemple, le tableau électrique 100 selon l'invention peut comprendre une pluralité d'interfaces de communication. Par exemple le tableau 100 peut disposer de trois canaux de communication : un canal Ethernet pour communiquer avec un boîtier d'un opérateur télécom pour un transfert des données collectées vers l'extérieur, un canal Wifi pour une consultation locale des données par le consommateur au moyen de dispositifs communiquant (tablette, PC, Smartphone ou autre) munis d'un logiciel adapté, et un canal radio pour recueillir des informations complémentaires dans l'installation...

Le tableau électrique 100 peut également présenter un port USB pour permettre une mise à jour et/ou une maintenance des logiciels de l'unité de traitement électronique 110, 110'. Le tableau électrique 100 peut aussi présenter une interface homme-machine (IHM) permettant une consultation in situ des données collectées et archivées par l'unité de traitement électronique 110, 110' après authentification du consommateur (saisi d'un code et/ou d'une donnée biométrique par exemple) et/ou permettant un paramétrage de l'unité de traitement électronique 110, 110' par le consommateur. Le paramétrage de l'unité électronique peut également être réalisé par le consommateur à l'aide d'un dispositif communiquant en Wifi (tablette, PC, Smartphone ou autre) munis d'un logiciel adapté

Le tableau électrique 100 décrit en référence à la figure 1 permet à un consommateur de contrôler ses usages électriques et de conserver un historique de ces usages. Par exemple, les données collectées par les capteurs de courant 105, 105' et archivées dans la mémoire du tableau peuvent être consultées par le consommateur (propriétaire et maitre du tableau électrique contrairement au compteur qui est contrôlé par le fournisseur d'énergie électrique) et transmises vers l'extérieure sur requête du consommateur. La requête de transmission vers l'extérieure des données collectées peut être ponctuelle ou le fait d'un paramétrage par le consommateur, pour une sauvegarde régulière des données par exemple.

Les usages électriques du consommateur peuvent ainsi être conservés à l'extérieur du logement et reconstitués, par exemple pour assister le consommateur dans l'optimisation de sa consommation électrique et/ou pour aider à établir des causes de défaillances en cas de sinistre.

Selon un mode de réalisation, l'unité de traitement électronique 110, 110' peut en outre être paramétrée pour détecter des anomalies de fonctionnement à partir des données collectées, notamment le déclenchement d'un disjoncteur et/ou le non fonctionnement d'un appareil (par exemple le congélateur ou le chauffage). L'unité de traitement électronique 110, 110' peut alors émettre une alerte à l'attention du consommateur via l'interface 115 de communication.

La figure 2 montre une installation comprenant le tableau électrique 100 décrit en référence à la figure 1.

La figure 2 montre une pluralité de capteurs domestiques 150. Ces capteurs domestiques 150 peuvent être installés dans le logement à la discrétion du consommateur ; ils peuvent inclure des capteurs d'humidité, de fumé, de qualité de l'air, de luminosité, de mouvement ou autre. L'unité de traitement électronique 110, 110' du tableau 100 collecte et archive en outre ces données recueillis par les capteurs domestiques 150. Un canal radio de l'interface de communication 115 du tableau peut par exemple être utilisé à cet effet.

Lorsque le tableau électrique 100 comprend une pluralité d'unités de traitement électroniques 110, 110' comme illustré sur les figures, une des unités est alors choisie comme unité maitre. Cette unité maitre peut collecter les données provenant des capteurs domestiques 150 et/ou rassembler l'ensemble des données collectées par les autres unités de traitement électroniques du tableau. En cas de défaillance de l'unité maitre, une autre des unités de traitement électroniques du tableau peut être élue comme unité maitre selon des procédés de communication entre unités électroniques connus en soi.

Les données ainsi collectées des capteurs domestiques 150 sont également archivées dans la mémoire du tableau 100, au même titre que les données collectées des capteurs de courant 105, 105', et peuvent être consultées par le consommateur et transmises vers l'extérieure sur requête du consommateur. Ces données collectées des capteurs domestiques 150 sont intégrées dans l'historique des usages du logement et peuvent ensuite servir au besoin à reconstituer des événements intervenus dans le logement.

Selon un mode de réalisation, l'unité de traitement électronique 110, 110' peut également être paramétrée pour détecter des anomalies de fonctionnement à partir des données collectées des capteurs domestiques 150, par exemple un défaut de qualité de l'air ou une détection d'intrusion. L'unité de traitement électronique 110, 110' peut alors émettre une alerte à l'attention du consommateur ou d'un tiers via l'interface 115 de communication.

La figure 2 montre aussi une multiprise 200 comprenant au moins un capteur de courant 201 par prise, adapté à mesurer un départ de courant et une différence de potentiel au niveau de chaque prise. La multiprise 200 comprend aussi une unité de traitement électronique 202 collectant des données de chaque capteur de courant 201 et une mémoire archivant les données ainsi collectée. La multiprise comprend en outre au moins une interface de communication 203.

Selon un mode de réalisation, l'unité de traitement électronique 202 de la multiprise 200 collecte et archive en outre des données d'au moins un capteur domestique 150. En effet, la position de certains capteurs domestiques 150 dans le logement peut être telle que leur communication avec le tableau 100 n'est pas garantie ; la multiprise 200 muni d'une interface de communication 203 et d'une unité de traitement électronique 202 peut alors servir de relais pour recueillir les données de certains capteurs dans certaines zones du logement.

L'unité de traitement électronique 202 de la multiprise 200 peut alors transmettre à l'unité de traitement électronique 110, 110' du tableau l'ensemble de ses données collectées et archivées - données collectées par chaque capteur de courant 201 et données collectées des capteurs domestiques 150 locaux. Le consommateur peut accéder aux données collectées par la multiprise 200 soit par le tableau comme décrit plus haut, soit directement en interrogeant la multiprise à l'aide d'un dispositif communiquant (tablette, PC, Smartphone ou autre) muni d'un logiciel adapté. L'interface de communication 203 de la multiprise 200 peut comprendre une ou plusieurs des interfaces décrites plus haut en référence à l'interface de communication 115 du tableau électrique 100, et notamment une interface Wifi ou une interface CPL.

La figure 2 montre encore une prise 300 comprenant au moins un capteur de courant 301 adapté à mesurer un départ de courant et une différence de potentiel. La prise 300 comprend également une unité de traitement électronique 302 collectant des données du capteur de courant 301 et une mémoire archivant les données ainsi collectées. La prise comprend en outre au moins une interface de communication 303.

Comme décrit plus haut en référence à la multiprise 200, la prise 300 peut également relayer la collecte de données provenant de capteurs domestiques 150. L'ensemble des données collectées par la prise 300 - données des capteurs de courant 301 et données collectées des capteurs domestiques 150 locaux - peuvent être transmises à l'unité de traitement électronique 110, 110' du tableau 100 et/ou consultées localement par le consommateur à l'aide d'un dispositif communiquant muni d'un logiciel adapté. L'interface de communication 303 de la prise 300 peut comprendre une ou plusieurs des interfaces décrites plus haut en référence à l'interface de communication 115 du tableau électrique 100, et notamment une interface Wifi ou une interface CPL.

Le tableau électrique 100 selon l'invention peut être utilisé pour contrôler une installation électrique domestique.

Un tel contrôle comprend la collecte de données à partir de capteurs 105, 105', 150, 201, 301 (capteurs de courant et capteurs domestiques le cas échéant, collecte centralisée au niveau du tableau et collecte relayée par prises et/ou multiprises locales le cas échéant) et l'archivage de ces données (dans la mémoire du tableau électrique 100 et localement dans les mémoires des prises 300 et/ou multiprises 200 le cas échéant). Les données collectées peuvent être horodatées par l'unité de traitement électronique 110, 110', 202, 302 assurant l'archivage.

Les solutions existantes, limitées en points de mesure de consommation d'usages, ne permettent pas de traiter la sécurité électrique, ni le confort et la qualité de bien être des occupants d'un logement.

Si plusieurs unités de traitement électroniques 110, 110', 202, 302 sont impliquées dans la collecte et l'archivage des données des capteurs, une étape de choix d'une unité maitre peut être réalisée pour coordonner la collecte et l'archivage des données, ainsi que la consultation des données archivées et leur transmission vers l'extérieur. L'élection d'une unité de traitement électronique comme unité maitre peut être faite de toute manière connue en soi. Si l'unité maitre choisie venait à être défaillante, une nouvelle élection d'une unité maitre parmi les unités électroniques opérationnelles interviendrait, de manière connue en soi.

Le contrôle d'une installation électrique selon l'invention comprend également la transmission et/ou la consultation, sur requête, des données collectées et archivées.

Par exemple, les données collectées sont stockées sur une carte µSD directement dans chacune des mémoires des unités de traitement électroniques, pour une durée glissante prédéterminée (quelques semaines ou quelques mois selon les paramétrages). Ces données peuvent alors être cycliquement dupliquées dans un coffre fort électronique sécurisé 50, extérieur au logement, sans limitation de durée. Le transfert de ces données peut être crypté et transiter via un boîtier télécom 20 avec une liaison ADSL. Un tel boitier télécom 20 comprend une interface de communication 21 qui peut communiquer avec l'interface de communication 115 du tableau 100 en Wifi ou par un câble Ethernet et éventuellement communiquer avec chaque interface de communication 203, 303 des multiprises 200 et/ou prises 300 le cas échéant.

Dans le cas d'une coupure électrique générale, chaque unité de traitement électronique peut posséder une autonomie suffisante pour sauvegarder les données et envoyer une alerte au consommateur ou à un tiers. Un dispositif automatique peut alors mettre en sommeil les capteurs et interrompre la collecte de données.

On peut prévoir une source de puissance autonome sur le tableau électrique 100 et/ou sur toute multiprise 200 ou prise 300 le cas échéant afin de maintenir la détection d'anomalies dans le logement en cas de coupure électrique générale. Par exemple, le tableau électrique 100 peut comprendre une batterie rechargeable assurant un fonctionnement dégradé du contrôle de l'installation en absence d'alimentation externe (sur secteur 12V DC ou par câble Ethernet POE par exemple).

Les solutions existantes ne permettent pas de fonctionner en mode dégradé. Si la « box opérateur » tombe en panne, plus aucune fonction n'est assurée.

Le consommateur peut aussi requérir, au moyen d'un dispositif communiquant muni d'un logiciel adapté (Smartphone 30 par exemple, PC ou autre), de consulter les données archivées dans chacune des mémoires des unités de traitement électroniques ou uniquement dans la mémoire du tableau qui peut centraliser l'ensemble des données collectées. Chacune des interfaces 115, 203, 303 permet de lire les données collectées, de les traiter, de les mettre en forme afin de permettre la mise en place de services à valeurs ajoutées personnalisés.

Les mesures de courant de chaque départ de disjoncteur du tableau électrique permettent de recueillir des informations de consommation détaillée. Ces informations permettent au consommateur de se sensibiliser, de gérer et d'optimiser sa consommation d'énergie dans son logement et d'avoir accès à un bilan détaillé de sa consommation électrique (au même titre qu'une facture de télécommunication ou d'un relevé bancaire mensuel de ses transactions).

Les solutions existantes centralisent les informations sur des serveurs externes contrôlés par les fournisseurs d'énergie pour créer les plateformes de services : ce sont des solutions intrusives où le consommateur n'a pas la maitrise de ses données.

Le contrôle d'une installation électrique selon l'invention comprend également la surveillance des données collectées pour détecter des anomalies de fonctionnement et l'émission d'une alerte en cas d'anomalie détectée.

Chaque unité de traitement électronique peut être paramétrée pour détecter des anomalies dans les données récoltées des capteurs. Elle peut alors envoyer des alertes au consommateur ou à un tiers paramétré sur déclenchement d'événements qui peuvent être :
- déclenchement d'un disjoncteur, sur défaut de court circuit ou surintensité,
- déclenchement du disjoncteur différentiel 30 mA de tête, sur défaut de fuite de courant sur un équipement,
- défaut de non fonctionnement d'un équipement : congélateur, chauffage, alarme...
- déclenchement de l'alarme intrusion,
- défaut de qualité de l'air, de température, d'humidité, de fuite d'eau ...
- alerte d'inactivité (surveillance d'une personne âgée par exemple).

Les solutions existantes ne permettent pas de traiter la sécurité électrique et sont encore limitées sur le traitement de la qualité de l'environnement d'un logement.

En cas de perte totale des alimentations (alimentation externe ou POE) avec passage sur batterie dans une prise 300 ou multiprise 200, un premier message peut être envoyé sur l'une des interfaces du consommateur et un second message peut être envoyé à l'unité de traitement électronique du tableau électrique 100 du logement.

Le consommateur peut ainsi gérer de manière personnalisée ses usages électriques et conserver de manière sécurisée un historique de données liées à son logement. Le tableau électrique selon l'invention est le coeur d'une plateforme de service du logement et permet
- une exhaustivité des usages en mesurant la consommation électrique détaillée ;
- une maitrise du coût avec la possibilité d'une seule unité de traitement au niveau du tableau ;
- une prise d'information simplifiée au niveau du tableau électrique puisque chaque équipement ou groupe d'équipements électrique est alimenté par le tableau.

L'invention a été décrite en référence à des modes de réalisations particuliers qui ne sont pas limitatifs. Notamment, le nombre et la nature des capteurs peuvent varier selon les applications, ainsi que les modes de transmission et de consultation des données collectées.

## Revendications

1. Tableau électrique (100), comprenant :
- au moins une rangée de disjoncteurs (101, 101') ;
- au moins un capteur de courant (105, 105') par disjoncteur, adapté à mesurer un départ de courant et une différence de potentiel ;
- au moins une unité de traitement électronique (110, 110') adaptée à collecter des données de chaque capteur de courant ;
- une mémoire adaptée à archiver les données collectées de chaque capteur de courant ;
- au moins une interface de communication (115), et
dans lequel l'unité de traitement électronique est adaptée à collecter et archiver en outre des données d'au moins un capteur domestique.

2. Tableau électrique selon la revendication 1, dans lequel l'unité de traitement électronique est adaptée à transmettre, sur requête, des données collectées et archivées.

3. Tableau électrique selon l'une des revendications 1 ou 2, dans lequel l'unité de traitement électronique est paramétrée pour détecter des anomalies de fonctionnement à partir des données collectées et adaptée à émettre une alerte.

4. Tableau électrique selon l'une quelconque des revendications précédentes, dans lequel l'interface de communication permet une consultation de l'ensemble des données collectées et archivées.

5. Tableau électrique selon l'une quelconque des revendications précédentes, comprenant une pluralité d'unités de traitement électroniques, une des unités étant choisie comme unité maitre.

6. Tableau électrique selon l'une quelconque des revendications précédentes, dans lequel l'interface de communication est au moins une parmi une connexion Ethernet, une connexion radio, une connexion WiFi, une connexion courant porteur de ligne (CPL).

7. Tableau électrique selon l'une quelconque des revendications précédentes, comprenant en outre une source de puissance autonome.

8. Installation électrique domestique, comprenant au moins un tableau électrique (100) selon l'une des revendications 1 à 7.

9. L'installation électrique selon la revendication 8, comprenant en outre au moins un capteur domestique (150).

10. L'installation électrique selon l'une des revendications 8 ou 9, comprenant en outre au moins un dispositif (30) comprenant une application logicielle permettant de consulter l'ensemble des données collectées et archivées.

11. L'installation électrique selon l'une des revendications 8 à 10, comprenant en outre au moins une multiprise (200) comprenant :
- au moins un capteur de courant (201) par prise, adapté à mesurer un départ de courant et une différence de potentiel ;
- une unité de traitement électronique (202) adaptée à collecter des données de chaque capteur de courant ;
- une mémoire adaptée à archiver les données collectées de chaque capteur de courant ;
- au moins une interface de communication (203).

12. L'installation électrique selon la revendication 11, dans laquelle l'unité de traitement électronique de la multiprise est adaptée à collecter et archiver en outre des données d'au moins un capteur domestique.

13. L'installation électrique selon l'une des revendications 11 ou 12, dans laquelle l'unité de traitement électronique de la multiprise est adaptée à transmettre à l'unité de traitement électronique du tableau l'ensemble de ses données collectées et archivées.

14. L'installation électrique selon l'une des revendications 8 à 13, comprenant en outre au moins une prise (300) comprenant :
- au moins un capteur de courant (301) adapté à mesurer un départ de courant et une différence de potentiel ;
- une unité de traitement électronique (302) adaptée à collecter des données du capteur de courant ;
- une mémoire adaptée à archiver les données collectées du capteur de courant ;
- au moins une interface de communication (303).

15. L'installation électrique selon la revendication 14, dans laquelle l'unité de traitement électronique de la prise est adaptée à collecter et archiver en outre des données d'au moins un capteur domestique.

16. L'installation électrique selon l'une des revendications 14 ou 15, dans laquelle l'unité de traitement électronique de la prise est adaptée à transmettre à l'unité de traitement électronique du tableau l'ensemble de ses données collectées et archivées.

17. Procédé de contrôle d'une installation électrique domestique selon l'une des revendications 8 à 16, le procédé comprenant les étapes de :
- collecte et archivage des données des capteurs ;
- transmission, sur requête, des données collectées et archivées ;
- consultation, sur requête, des données collectées et archivées.

18. Procédé de contrôle selon la revendication 17, comprenant en outre les étapes de :
- surveillance des données collectées pour détecter des anomalies de fonctionnement ;
- émission d'une alerte en cas d'anomalie détectée.

19. Procédé de contrôle selon l'une des revendications 17 ou 18, l'installation comprenant une pluralité d'unités de traitement électroniques, le procédé comprenant en outre l'étape de choix d'une des unités comme unité maitre.

20. Procédé de contrôle selon la revendication 19, dans lequel l'unité maitre assure la transmission et la consultation, sur requête, de l'ensemble des données collectées et archivées.
